# EUROPEAN PATENT APPLICATION

(11) **EP 4 529 406 A1**
(43) Date of publication of application: **26.03.2025**
(21) Application number: 23807692.1
(22) Date of filing: 18.05.2023
(51) Int. Cl.: H10N 15/20

(54) **THERMOELECTRIC CONVERSION ELEMENT AND THERMOELECTRIC CONVERSION DEVICE**

(30) Priority: 18.05.2022 JP 2022081825
(71) Applicant: The University of Tokyo, Bunkyo-ku, Tokyo 113-8654 (JP)
(72) Inventor: NAKATSUJI, Satoru, Tokyo 113-8654 (JP); SAKAI, Akito, Tokyo 113-8654 (JP)
(74) Representative: Bandpay & Greuter
(86) International application number: PCT/JP2023/018578
(87) International publication number: WO 2023/224091

(57) **Abstract**

A thermoelectric conversion element (1) is made of a material that is able to be magnetized in any direction at zero magnetic field, has a box shape extending in one direction (direction y), and is magnetized in a direction +z. When heat current Q (~-VT) flows through the thermoelectric conversion element (1) in a direction +x, a temperature difference is created in the direction +x. As a result, the anomalous Nernst effect generates electromotive force V (~M×(-VT)) in the thermoelectric conversion element (1) in an outer product direction (direction y) perpendicular to both the direction of the heat current Q (direction +x) and the direction of magnetization M (direction +z). Examples of the material of the thermoelectric conversion element (1) include a ferrimagnet with a composition of R₂Co₇ where R is a rare-earth element.

## Description

### Technical Field

The present invention relates to a thermoelectric conversion element and a thermoelectric conversion device.

### Background Art

Thermoelectric modules are used for converting a temperature difference of a substance into voltage. Most thermoelectric modules so far have been based on the Seebeck effect. However, the Seebeck-effect-based modules have not been in widespread use because they have a complex structure and a problem of materials. Meanwhile, thermoelectric modules based on the anomalous Nernst effect have attracted enormous attention because they have a simple structure and use versatile materials, although the figure of merit in the anomalous Nernst effect is lower than that in the Seebeck effect (e.g., See Patent Literature 1).

### Citation List

### Patent Literature

Patent Literature 1: Japanese Laid-Open Patent Publication No. 2021-128998

### Summary of Invention

### Technical Problem

The anomalous Nernst effect typically appears in ferromagnets which are very sensitive to an external magnetic field. On the other hand, the ferromagnets are less likely to exhibit the anomalous Nernst effect at zero magnetic field regardless of their shapes. Therefore, in order to stably use thermoelectric modules based on the anomalous Nernst effect, it is highly important to use a material that is insensitive to an external magnetic field.

In view of the foregoing, an object of the invention is to provide a thermoelectric conversion element and a thermoelectric conversion device that are stable against the external magnetic field.

### Solution to Problem

A thermoelectric conversion element according to a first aspect of the invention is made of a material that is able to be magnetized in any direction at zero magnetic field and configured to exhibit an anomalous Nernst effect.

A thermoelectric conversion device according to a second aspect of the invention includes a substrate and a plurality of thermoelectric conversion elements on the substrate. Each of the plurality of thermoelectric conversion elements has a shape extending in one direction, is made of a material that is able to be magnetized in any direction at zero magnetic field, and is configured to exhibit an anomalous Nernst effect. The plurality of thermoelectric conversion elements are arranged in parallel to one another in a direction perpendicular to the one direction and electrically connected in series.

A thermoelectric conversion device according to a third aspect of the invention includes a first substrate; a plurality of first thermoelectric conversion elements on the first substrate, each of the plurality of first thermoelectric conversion elements having a shape extending in one direction, being made of a first material that is able to be magnetized in any direction at zero magnetic field, and being configured to exhibit an anomalous Nernst effect, the plurality of first thermoelectric conversion elements being arranged in parallel to one another in a direction perpendicular to the one direction; a second substrate; and a plurality of second thermoelectric conversion elements on the second substrate, each of the plurality of second thermoelectric conversion elements having a shape extending in the one direction, being made of a second material that is able to be magnetized in any direction at zero magnetic field, and being configured to exhibit the anomalous Nernst effect, the plurality of second thermoelectric conversion elements being arranged in parallel to one another in a direction perpendicular to the one direction. Nernst coefficients of the first material and the second material are opposite in sign to each other, and the plurality of first thermoelectric conversion elements and the plurality of second thermoelectric conversion elements are connected alternately and electrically in series such that the plurality of first thermoelectric conversion elements and the plurality of second thermoelectric conversion elements are magnetized in an identical direction.

### Advantageous Effects of Invention

According to the invention, by using a material that exhibits the anomalous Nernst effect and is able to be magnetized in any direction at zero magnetic field, it is possible to achieve thermoelectric conversion that is stable against an external magnetic field.

### Brief Description of Drawings

FIG. 1 is a schematic view for illustrating a thermoelectric mechanism in a thermoelectric conversion element according to embodiments.
FIG. 2 is a graph illustrating temperature dependence of Hall resistivity for GdCo₃, Gd₂Co₇, and GdCo₅, and temperature dependence of magnetization for Gd₂Co₇.
FIG. 3A is a schematic view of a Gd₂Co₇-type crystal structure.
FIG. 3B is a schematic view of a Ce₂Ni₇-type crystal structure.
FIG. 4A is a graph illustrating magnetic field dependence of a Nernst coefficient for Gd₂Co₇ single crystal.
FIG. 4B is a graph illustrating magnetic field dependence of a Nernst coefficient for Ho_{1.2}Gd_{0.8}Co₇ single crystal.
FIG. 4C is a graph illustrating temperature dependence of magnetization for Ho_{1.2}Gd_{0.8}Co₇.
FIG. 4D is a graph illustrating temperature dependence of magnetization for various Gd-Co alloys.
FIG. 4E is a graph illustrating Nernst coefficients of R₂Co₇ polycrystals for various rare-earth elements R.
FIG. 5 is a perspective view illustrating a configuration of a thermoelectric conversion device according to Example 1 of the embodiments.
FIG. 6A is a schematic view illustrating a configuration of a first structural body for a thermoelectric conversion device according to Example 2 of the embodiments.
FIG. 6B is a schematic view illustrating a configuration of a second structural body for the thermoelectric conversion device according to Example 2 of the embodiments.
FIG. 7 is a schematic view illustrating a configuration of the thermoelectric conversion device according to Example 2.
FIG. 8 is an exterior schematic view of the thermoelectric conversion device according to Example 2.

### Description of Embodiments

Exemplary embodiments of the invention will be described below with reference to the accompanying drawings. The same reference signs are used to designate the same or similar elements throughout the drawings. The drawings are schematic, and a relationship between a planar dimension and a thickness and a thickness ratio between members are different from reality. Needless to say, there are portions having different dimensional relationships or ratios between the drawings.

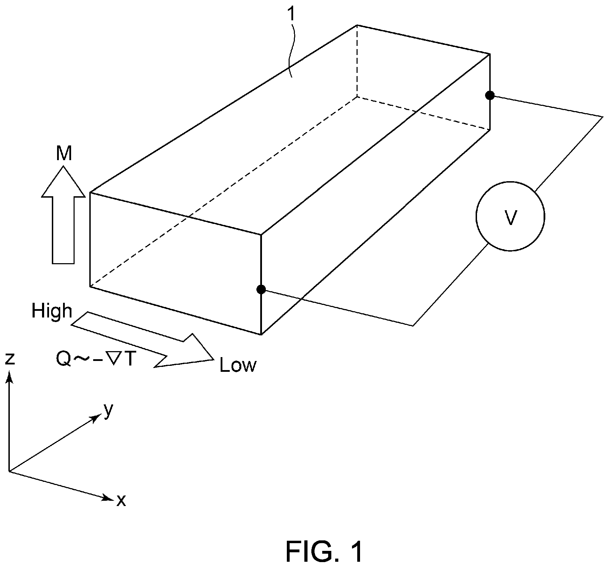

First, a thermoelectric conversion element according to the embodiments of the invention and a thermoelectric mechanism thereof will be described with reference to FIG. 1.

As shown in FIG. 1, an assumption is made that a thermoelectric conversion element 1 according to the embodiments has a box shape extending in one direction (direction y), has a predefined thickness (length in a direction z), and is magnetized in a direction +z. When heat current Q (~-VT) flows through the thermoelectric conversion element 1 in a direction +x, a temperature difference is created in the direction +x. As a result, the anomalous Nernst effect generates electromotive force V (~M×(-VT)) in the thermoelectric conversion element 1 in an outer product direction (direction y) perpendicular to both the direction of the heat current Q (direction +x) and the direction of magnetization M (direction +z).

The embodiments are directed to thermoelectric conversion elements made of a material that is able to be magnetized in any direction at zero magnetic field and configured to exhibit the anomalous Nernst effect. To be magnetized in any direction at zero magnetic field, magnetic shape anisotropy needs to be small. To achieve this, the magnetization needs to be small. Specifically, the magnetization is preferably 2kG (kilogauss) or less, more preferably 1kG or less at a temperature in an actual use environment.

Materials that are able to be magnetized in any direction at zero magnetic field include ferromagnets, antiferromagnets, and ferrimagnets, such as an alloy made of a rare-earth element (R) and cobalt (Co). Examples of such R-Co alloys include RCo₂ (R=Gd), RCo₃ (R=Gd, Tb, Dy, Er, Tm, Lu), R₂Co₇ (R=Y, La, Ce, Pr, Nd, Sm, Gd, Tb, Dy, Ho, Er, Tm, Lu), R₅Co₁₉ (R=La, Pr, Nd, Sm), RCo₅ (R=Y, La, Ce, Pr, Nd, Sm, Gd, Tb, Dy, Ho, Er), R₂Co₁₇ (R=Y, Ce, Pr, Nd, Sm, Gd, Tb, Dy, Ho, Er, Tm, Yb, Lu), RCo₁₃ (R=La), R1₂₋ₓR2ₓCo_{y} (where 0<x<2, and R1 and R2 are different rare-earth elements from each other). The main focus below will be on ferrimagnets which have a smaller magnetization than ferromagnets and can exhibit the anomalous Nernst effect at zero magnetic field regardless of their shapes.

Ferrimagnets have a magnetization compensation temperature Tₖ, and have two different sublattices. The relative magnitude of magnetization between the sublattices is reversed around Tₖ. For this reason, ferrimagnets have a relatively small magnetization and a weak magnetic shape anisotropy near Tₖ. With this feature, the magnetization of ferrimagnets can be stably oriented in any direction unlike ferromagnets. This tiny magnetization can be stably oriented in any direction, such as a direction perpendicular to or oblique to a longitudinal direction of a thin wire.

Tₖ of the alloy of a rare-earth element and Co among ferrimagnets is known to lie around room temperature. As shown in Table 1, for ferrimagnets with a composition of R₂Co₇ where R is a rare-earth element, Tₖ is 428K when R is Gd, and Tₖ monotonically decreases with an increase in atomic number of R (Tb, Dy, Ho, Er). Each of these compounds has Curie temperature T_{c} way above room temperature (300K) and remains stable until temperature reaches about 600K to 700K.

**[Table 1]**

| Compound | *T_{c}* | *T*ₖ |
|---|---|---|
| Pr₂Co₇ | 574 | |
| Nd₂Co₇ | 609 | |
| Sm₂Co₇ | 713 | |
| Gd₂Co₇ | 775 | 428 |
| Tb₂Co₇ | 717 | 410 |
| Dy₂Co₇ | 640 | 380 |
| Ho₂Co₇ | 647 | 230 |
| Er₂Co₇ | 623 | 140 |

Here, Table 1 and after-mentioned Table 2 are based on the following literature:
"Duc N H. Intersublattice Exchange Coupling in The Rare Earth-Transition Metal Intermetallics[J]. Handbook on the Physics and Chemistry of Rare Earths; Gschneidner, KA, Jr., Eyring, L., Eds, 2014: 339-398."

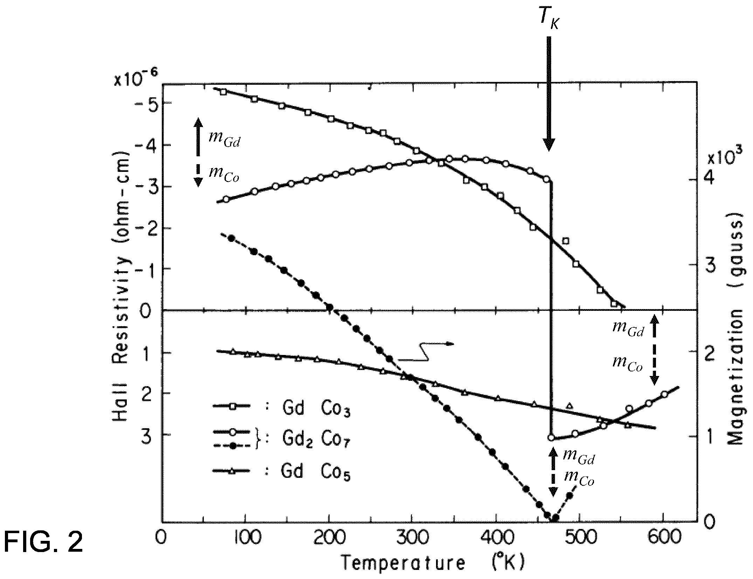

FIG. 2 shows temperature dependence of Hall resistivity for GdCo₃ single crystal, Gd₂Co₇ single crystal, and GdCo₅ single crystal, and temperature dependence of magnetization for Gd₂Co₇ single crystal. FIG. 2 is based on the following literature:
Ogawa A, Katayama T, Hirano M, et al. General Treatment of Anomalous Hall Effect and Kerr Rotation in Rare Earth Cobalt Systems[J]. Japanese Journal of Applied Physics, 1976, 15(S1): 87.

As shown in FIG. 2, for a ferrimagnet Gd₂Co₇, magnetization of Gd (up arrow) and magnetization of Co (down arrow) are oriented opposite to each other, Gd has larger magnetization than Co at a temperature below Tₖ, and Gd has a smaller magnetization than Co at a temperature above Tₖ. The magnetization of Gd and the magnetization of Co are compensated at Tₖ, which leads to zero magnetization of Gd₂Co₇ (filled circle). The Hall resistivity of Gd₂Co₇ (open circle) is sign-reversed at Tₖ. The sign reversal of the anomalous Hall effect (Hall resistivity) at Tₖ leads to the sign reversal of the anomalous Nernst effect (Nernst coefficient).

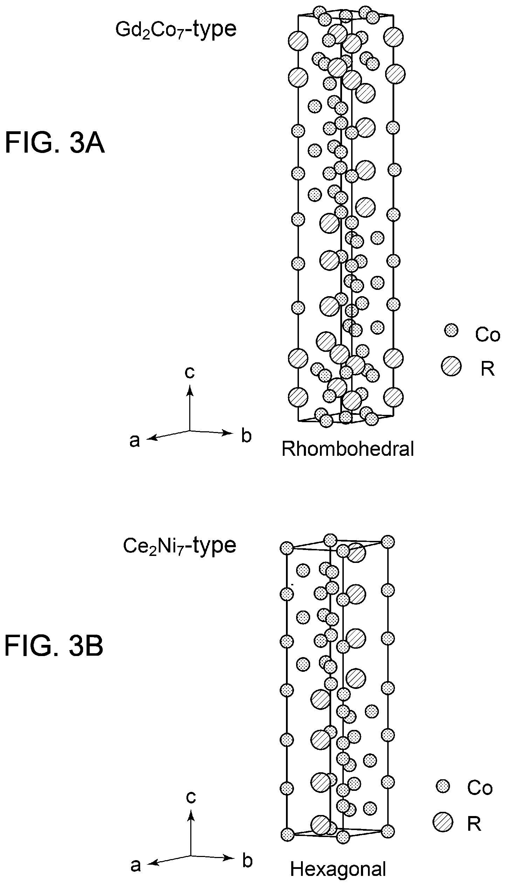

As shown in FIGS. 3A and 3B, R₂Co₇ has two types of crystal structures: rhombohedral Gd₂Co₇-type structure and hexagonal Ce₂Ni₇-type structure. The rhombohedral structure shown in FIG. 3A has a space group of R-3m with lattice constants a=5.023Å, b=5.023Å, c=36.315Å, α=90.000°, β=90.000°, γ=120.000°. The hexagonal structure shown in FIG. 3B has a space group of P6₃/mmc with lattice constants a=5.022Å, b=5.022Å, c=24.190Å, α=90.000°, β=90.000°, γ=120.000°. A length in c-axis of the rhombohedral structure is thus about 1.5 times longer than that of the hexagonal structure.

Table 2 shows crystal structures of R₂Co₇ where R=Y, Ce, Pr, Nd, Sm, Gd, Tb, Dy, Ho, Er, Lu. Ce₂Co₇, Pr₂Co₇, Sm₂Co₇, and Gd₂Co₇ can have both rhombohedral and hexagonal structures.

**[Table 2]**

| | |
|---|---|
| Crystal structure | R₂Co₇ |
| Rhombohedral | Y₂Co₇, Tb₂Co₇, Dy₂Co₇, Ho₂Co₇, Er₂Co₇, Lu₂Co₇ |
| Hexagonal or Rhombohedral | Ce₂Co₇, Pr₂Co₇, Sm₂Co₇, Gd₂Co₇ |
| Hexagonal | Nd₂Co₇ |

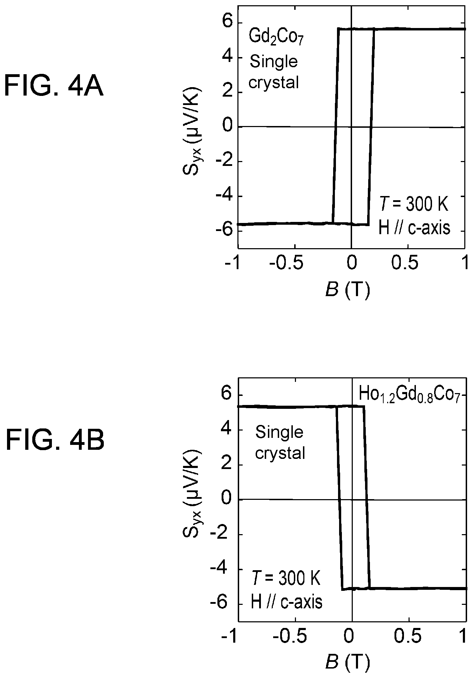

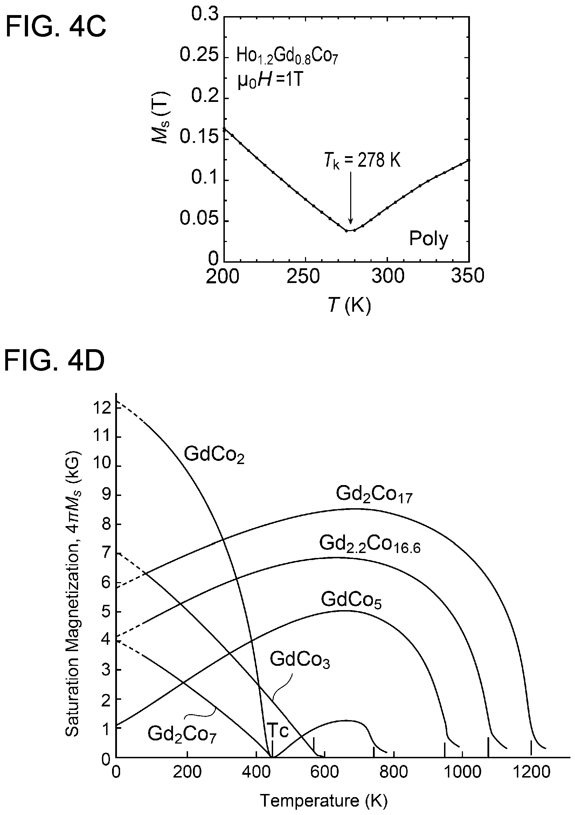

FIG. 4A shows magnetic field dependence of a Nernst coefficient for Gd₂Co₇ single crystal at 300K when the magnetic field is applied parallel to c-axis. FIG. 4B shows magnetic field dependence of a Nernst coefficient for Ho_{1.2}Gd_{0.8}Co₇ single crystal at 300K when the magnetic field is applied parallel to c-axis. FIG. 4C shows temperature dependence of magnetization for Ho_{1.2}Gd_{0.8}Co₇ when the magnetic field of 1T is applied. As described above, Tₖ of Gd₂Co₇ is sufficiently higher than room temperature (See Table 1). Tₖ of Ho_{1.2}Gd_{0.8}Co₇, on the other hand, is 278K which is lower than room temperature as shown in FIG. 4C.

FIGS. 4A and 4B reveal that the Nernst coefficient of Gd₂Co₇ and the Nernst coefficient of Ho_{1.2}Gd_{0.8}Co₇ are opposite in sign to each other but share almost the same absolute value at room temperature (300K). The absolute value of the Nernst coefficients of both materials is close to the world-record value (~6µV/K) at room temperature.

FIGS. 4A and 4B reflect the fact that Gd₂Co₇ and Ho_{1.2}Gd_{0.8}Co₇ have a significantly small magnetization and a large coercive force at room temperature. This indicates that once the magnetization is oriented in a specific direction by the magnetic field, the direction of the magnetization is maintained, which makes it hard to orient the magnetization in the opposite direction. Furthermore, since these materials have a tiny magnetization, the magnetic shape anisotropy is weak. For example, the magnetization can be manipulated in any direction, which is not limited to a longitudinal direction of a thin wire.

FIG. 4D shows temperature dependence of magnetization for Gd₂Co₇, GdCo₂, GdCo₃, GdCo₅, Gd_{2.2}Co_{16.6}, and Gd₂Co₁₇. FIG. 4D is based on the following literature:
Katayama T, Shibata T, Magnetic properties of some gadolinium-Cobalt intermetallic compounds[J]. Journal of Magnetism and Magnetic Materials, 1981, 23(2): 173-182.

As is clear from FIG. 4D, the magnetization value of the ferrimagnet Gd₂Co₇ is one-tenth to one-fifth the magnetization value of ferromagnets such as GdCo₅. The magnetization value can be further decreased by fine-tuning a composition of rare-earth elements. Specifically, when R₂Co₇ is doped with another rare-earth element, a ternary compound with a smaller magnetization can be obtained, such as Ho_{1.2}Gd_{0.8}Co₇ shown in FIGS. 4B and 4C. That is, it is possible to obtain a ternary compound with a small magnetization having a composition of R1₂₋ₓR2ₓCo₇ (where 0<x<2, and R1 and R2 are different rare-earth elements from each other).

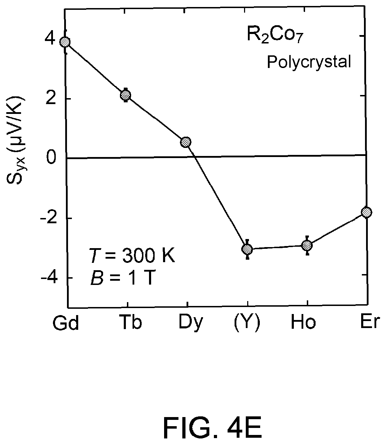

FIG. 4E shows Nernst coefficients of R₂Co₇ polycrystals where R=Gd, Tb, Dy, Y, Ho, and Er when the magnetic field B of 1T is applied at 300K. FIG. 4E reveals that absolute values of the Nernst coefficients of R₂Co₇ polycrystals (Especially, R=Gd, Tb, Y, Ho, Er) are also relatively large (about 2µV/K to 4µV/K).

As described above, by using the thermoelectric conversion element 1 made of a material that is able to be magnetized in any direction at zero magnetic field, such as a ferrimagnet and exhibits the anomalous Nernst effect, it is possible to achieve thermoelectric conversion that is stable against an external magnetic field such as a leak field from a motor.

Next, reference will be made to thermoelectric conversion devices according to Example 1 and Example 2 each including the thermoelectric conversion element 1 of the embodiments in the form of modules.

### Example 1

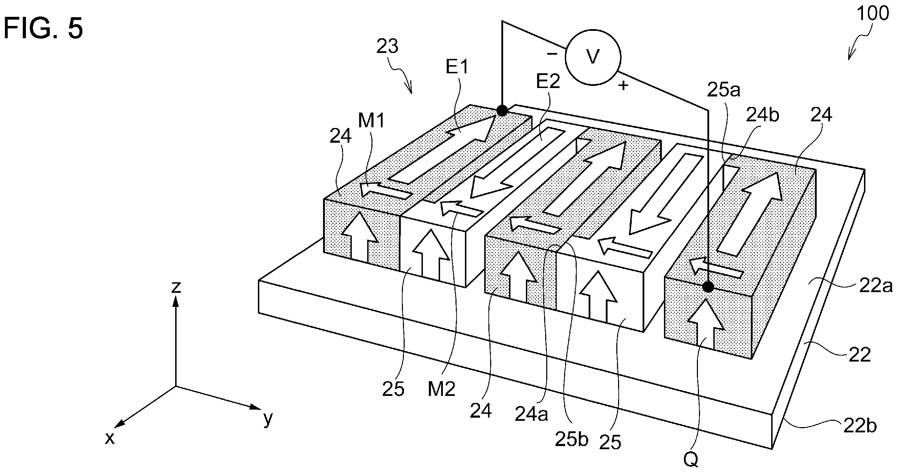

FIG. 5 shows an exterior configuration of a thermoelectric conversion device 100 according to Example 1 of the embodiments. The thermoelectric conversion device 100 includes a substrate 22 and a power generator 23 placed on the substrate 22. In the thermoelectric conversion device 100, when the heat current Q flows from the substrate 22 side toward the power generator 23, a temperature difference is created in the power generator 23 in the direction of the heat current, and an electric voltage V is generated in the power generator 23 by the anomalous Nernst effect.

The substrate 22 has a first face 22a on which the power generator 23 is placed, and a second face 22b opposite to the first face 22a. Heat from a heat source (not shown) is applied onto the second face 22b. Examples of the material of the substrate 22 include, but are not limited to, MgO, Si, SiO₂, and Al₂O.

The power generator 23 includes a plurality of first thermoelectric conversion elements 24 and a plurality of second thermoelectric conversion elements 25, which are the same in size and have a three-dimensional L shape. The first thermoelectric conversion element 24 has the Nernst coefficient which is opposite in sign to the Nernst coefficient of the second thermoelectric conversion element 25. The first thermoelectric conversion element 24 and the second thermoelectric conversion element 25 are made of a first material and a second material, respectively, both of which are able to be magnetized in any direction at zero magnetic field. For example, the first material and the second material are different ferrimagnets from each other. For example, Gd₂Co₇ (FIG. 4A) and Ho_{1.2}Gd_{0.8}Co₇ (FIG. 4B) can be employed as the first material and the second material, respectively.

As shown in FIG. 5, the plurality of first thermoelectric conversion elements 24 and the plurality of second thermoelectric conversion elements 25 are alternately arranged in parallel to one another on the substrate 22 in a direction (direction y) perpendicular to a longitudinal direction (direction x) of each thermoelectric conversion element. The first thermoelectric conversion element 24 and the second thermoelectric conversion element 25 are arranged such that magnetization M1 of the first thermoelectric conversion element 24 and magnetization M2 of the second thermoelectric conversion element 25 are oriented in an identical direction. The number of the first thermoelectric conversion elements 24 and the second thermoelectric conversion elements 25 that constitute the power generator 23 is not restrictive.

Each of the first thermoelectric conversion elements 24 has one side (+y side) and the other side (-y side) along the longitudinal direction (direction x), and a +x portion on one side is defined as a first end face 24a and a -x portion on the other side is defined as a second end face 24b. Each of the second thermoelectric conversion elements 25 has one side (+y side) and the other side (-y side) along the longitudinal direction (direction x), and a -x portion on one side is defined as a first end face 25a and a +x portion on the other side is defined as a second end face 25b.

The first end face 25a of the second thermoelectric conversion element 25 is connected to the second end face 24b of the first thermoelectric conversion element 24 adjacent thereto in the direction +y, and the second end face 25b of the second thermoelectric conversion element 25 is connected to the first end face 24a of the first thermoelectric conversion element 24 adjacent thereto in the direction -y. With this structure, the plurality of first thermoelectric conversion elements 24 and the plurality of second thermoelectric conversion elements 25 are electrically connected in series to one another. That is, the power generator 23 is placed on the first face 22a of the substrate 22 in a serpentine shape. The first thermoelectric conversion element 24 and the second thermoelectric conversion element 25 are electrically insulated from each other except for the connecting portion.

When heat is applied from the heat source onto the second face 22b of the substrate 22, the heat current Q flows in the direction +z toward the power generator 23. When the heat current Q creates a temperature difference, the anomalous Nernst effect causes each of the first thermoelectric conversion elements 24 to generate electromotive force E1 in the direction (direction -x) perpendicular to both the direction of the magnetization M1 (direction -y) and the direction of the heat current Q (direction +z). The anomalous Nernst effect causes each of the second thermoelectric conversion elements 25 to generate electromotive force E2 in the direction (direction +x) perpendicular to both the direction of the magnetization M2 (direction -y) and the direction of the heat current Q (direction +z).

Since the first thermoelectric conversion elements 24 and the second thermoelectric conversion elements 25, which are arranged in parallel to one another, are electrically connected in series to one another as described above, the electromotive force E1 generated in one first thermoelectric conversion element 24 can be applied to the adjacent second thermoelectric conversion element 25. Since the direction of the electromotive force E1 generated in the one first thermoelectric conversion element 24 is opposite to the direction of the electromotive force E2 generated in the adjacent second thermoelectric conversion element 25, the electromotive force in the first thermoelectric conversion element 24 and the electromotive force in the adjacent second thermoelectric conversion element 25 are added up, thereby increasing an output voltage V.

### Example 2

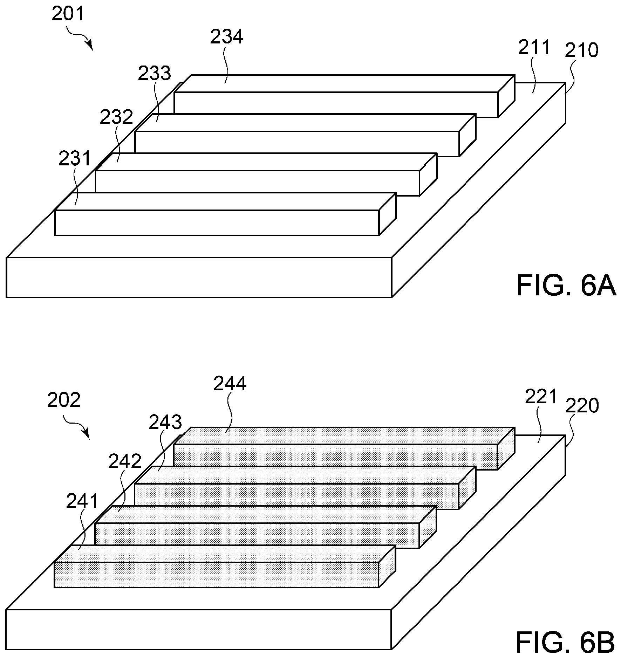

Next, Example 2 of the embodiments will be explained with reference to FIGS. 6A to 8.

Example 1 is directed to the thermoelectric conversion device 100 including the first thermoelectric conversion element 24 and the second thermoelectric conversion element 25, whose Nernst coefficients are opposite in sign to each other, placed on the same face of the substrate 22. Example 2 will be directed to a thermoelectric conversion device including such two kinds of thermoelectric conversion elements placed on different substrates.

The thermoelectric conversion device according to Example 2 includes a first structural body 201 shown in FIG. 6A and a second structural body 202 shown in FIG. 6B. As shown in FIG. 6A, the first structural body 201 includes a first substrate 210 and a plurality of first thermoelectric conversion elements 231 to 234, which are box-shaped elements with the same size, placed on a first face 211 of the first substrate 210. The first thermoelectric conversion elements 231 to 234 are arranged in an equidistant manner in parallel to one another in a direction perpendicular to a longitudinal direction thereof. Similarly, as shown in FIG. 6B, the second structural body 202 includes a second substrate 220 and a plurality of second thermoelectric conversion elements 241 to 244 placed on a first face 221 of the second substrate 220. The second thermoelectric conversion elements 241 to 244 have the same shape and size as those of the first thermoelectric conversion elements 231 to 234, and are arranged in an equidistant manner in parallel to one another in a direction perpendicular to a longitudinal direction thereof. These thermoelectric conversion elements are formed on the substrates using, for example, a sputtering method. Examples of a material of the first substrate 210 and the second substrate 220 include, but are not limited to, MgO, Si, SiO₂, and Al₂O₃.

The first thermoelectric conversion elements 231 to 234 are made of a first material, and the second thermoelectric conversion elements 241 to 244 are made of a second material. Nernst coefficients of the first material and the second material are opposite in sign to each other. The first material and the second material are able to be magnetized in any direction at zero magnetic field, and are, for example, different ferrimagnets from each other. For example, Gd₂Co₇ (FIG. 4A) and Ho_{1.2}Gd_{0.8}Co₇ (FIG. 4B) can be employed as the first material and the second material, respectively.

In FIGS. 6A to 8, the four first thermoelectric conversion elements 231 to 234 are arranged on the first substrate 210, and the four second thermoelectric conversion elements 241 to 244 are arranged on the second substrate 220. Needless to say, the number of the thermoelectric conversion elements on each substrate is not restrictive.

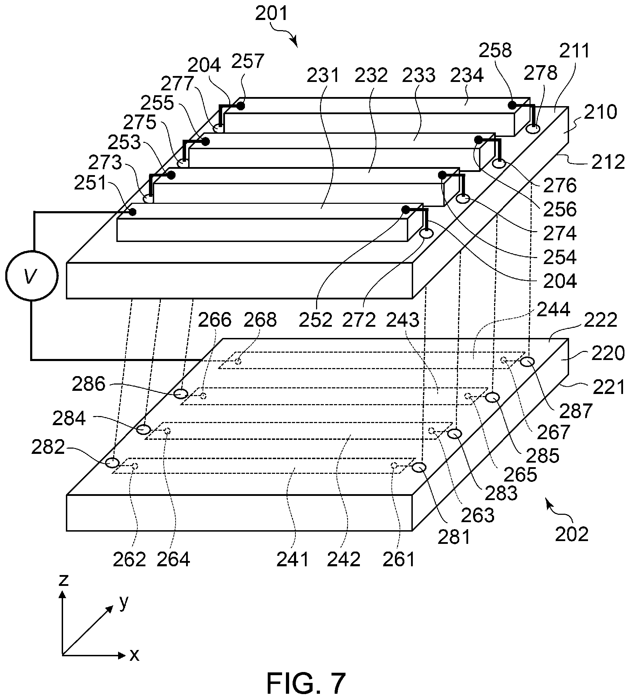

The first substrate 210 has through-holes that penetrate the first substrate 210 near one end or both ends of each first thermoelectric conversion element in the longitudinal direction. Specifically, as shown in FIG. 7, the first substrate 210 has a through-hole 272 near one end of the first thermoelectric conversion element 231, through-holes 273 and 274 near both ends of the first thermoelectric conversion element 232, through-holes 275 and 276 near both ends of the first thermoelectric conversion element 233, and through-holes 277 and 278 near both ends of the first thermoelectric conversion element 234.

Similarly, the second substrate 220 has through-holes that penetrate the second substrate 220 near one end or both ends of each second thermoelectric conversion element in the longitudinal direction. Specifically, as shown in FIG. 7, the second substrate 220 has through-holes 281 and 282 near both ends of the second thermoelectric conversion element 241, through-holes 283 and 284 near both ends of the second thermoelectric conversion element 242, through-holes 285 and 286 near both ends of the second thermoelectric conversion element 243, and a through-hole 287 near one end of the second thermoelectric conversion element 244.

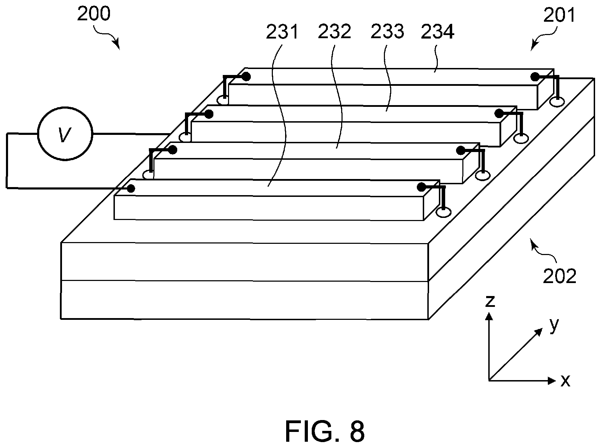

Conductive wires 204 run through each of the through-holes of the first substrate 210 and the second substrate 220. Each of the first thermoelectric conversion elements has a first terminal and a second terminal on both ends thereof, and each of the second thermoelectric conversion elements has a first terminal and a second terminal on both ends thereof. The conductive wires 204 are connected to the first terminals and the second terminals. The first substrate 210 and the second substrate 220 have a second face 212 and a second face 222, respectively, and these second faces are bonded with an adhesive to constitute a thermoelectric conversion device 200 as shown in FIG. 8.

As shown in FIG. 7, a second terminal 252 of the first thermoelectric conversion element 231 is connected to a first terminal 261 of the second thermoelectric conversion element 241 via the through-holes 272 and 281, a second terminal 262 of the second thermoelectric conversion element 241 is connected to a first terminal 253 of the first thermoelectric conversion element 232 via the through-holes 282 and 273, a second terminal 254 of the first thermoelectric conversion element 232 is connected to a first terminal 263 of the second thermoelectric conversion element 242 via the through-holes 274 and 283, a second terminal 264 of the second thermoelectric conversion element 242 is connected to a first terminal 255 of the first thermoelectric conversion element 233 via the through-holes 284 and 275, a second terminal 256 of the first thermoelectric conversion element 233 is connected to a first terminal 265 of the second thermoelectric conversion element 243 via the through-holes 276 and 285, a second terminal 266 of the second thermoelectric conversion element 243 is connected to a first terminal 257 of the first thermoelectric conversion element 234 via the through-holes 286 and 277, and a second terminal 258 of the first thermoelectric conversion element 234 is connected to a first terminal 267 of the second thermoelectric conversion element 244 via the through-holes 278 and 287.

As described above, the first thermoelectric conversion elements 231 to 234 and the second thermoelectric conversion elements 241 to 244 are connected alternately and electrically in series. In FIGS. 7 and 8, the first thermoelectric conversion elements 231 to 234 and the second thermoelectric conversion elements 241 to 244 are magnetized in an identical direction (direction +y).

For example, when heat current Q flowing in a direction +z through the thermoelectric conversion device 200 creates a temperature difference, the anomalous Nernst effect generates electromotive force in a direction +x in the first thermoelectric conversion elements 231 to 234 and generates electromotive force in a direction -x in the second thermoelectric conversion elements 241 to 244. All of the electromotive forces generated in the thermoelectric conversion elements are added up to output a voltage V between a first terminal 251 of the first thermoelectric conversion element 231 and a second terminal 268 of the second thermoelectric conversion element 244.

In Example 2, by forming the first and second thermoelectric conversion elements having Nernst coefficients which are opposite in sign to each other on different substrates to fabricate the first structural body 201 and the second structural body 202, respectively, it is possible to fabricate the thermoelectric conversion device 200 by a simple process. The number of the thermoelectric conversion elements of the thermoelectric conversion device 200 is nearly two times greater than that of the thermoelectric conversion device 100 which includes the first thermoelectric conversion elements 24 and the second thermoelectric conversion elements 25 on the same face of the substrate 22 as demonstrated in Example 1 (FIG. 5). This makes it possible to increase an output voltage.

In FIGS. 7 and 8, the second face 212 of the first substrate 210 and the second face 222 of the second substrate 220 are bonded so that the first face 211 of the first substrate 210 and the first face 221 of the second substrate 220 face opposite directions. In an alternative configuration, these first faces 211 and 221 may face the same direction.

The first substrate 210 and the second substrate 220 may not necessarily have the through-holes. The conductive wires 204 may run outside the first substrate 210 and the second substrate 220, provided that the first thermoelectric conversion elements 231 to 234 on the first substrate 210 and the second thermoelectric conversion elements 241 to 244 on the second substrate 220 are connected in series by the conductive wires 204.

### Reference Signs List

1: Thermoelectric conversion element
22: Substrate
23: Power generator
24, 231, 232, 233, 234: First thermoelectric conversion element
25, 241, 242, 243, 244: Second thermoelectric conversion element
100, 200: Thermoelectric conversion device
201: First structural body
202: Second structural body
204: Conductive wire
210: First substrate
211: First face
212: Second face
220: Second substrate
221: First face
222: Second face
251, 253, 255, 257, 261, 263, 265, 267: First terminal
252, 254, 256, 258, 262, 264, 266, 268: Second terminal
272 to 278, 281 to 287: Through-hole

## Claims

1. A thermoelectric conversion element made of a material that is able to be magnetized in any direction at zero magnetic field and configured to exhibit an anomalous Nernst effect.

2. The thermoelectric conversion element according to claim 1, wherein
magnetization of the material is 2 kilogauss or less at a predefined temperature.

3. The thermoelectric conversion element according to claim 1, wherein
the material is an alloy made of a rare-earth element and Co.

4. The thermoelectric conversion element according to claim 1, wherein
the material is a ferrimagnet.

5. The thermoelectric conversion element according to claim 4, wherein
the ferrimagnet has a composition of R₂Co₇ where R is a rare-earth element.

6. The thermoelectric conversion element according to claim 4, wherein
the ferrimagnet has a composition of R1₂₋ₓR2ₓCo_{y} where R1 and R2 are different rare-earth elements from each other and 0<x<2.

7. A thermoelectric conversion device comprising:
a substrate; and
a plurality of thermoelectric conversion elements on the substrate, each of the plurality of thermoelectric conversion elements having a shape extending in one direction, being made of a material that is able to be magnetized in any direction at zero magnetic field, and being configured to exhibit an anomalous Nernst effect, the plurality of thermoelectric conversion elements being arranged in parallel to one another in a direction perpendicular to the one direction and electrically connected in series.

8. The thermoelectric conversion device according to claim 7, wherein
two adjacent thermoelectric conversion elements of the plurality of thermoelectric conversion elements are made of a first material and a second material, respectively, and Nernst coefficients of the first material and the second material are opposite in sign to each other, and
the plurality of thermoelectric conversion elements are arranged such that the plurality of thermoelectric conversion elements are magnetized in an identical direction.

9. The thermoelectric conversion device according to claim 8, wherein
the first material and the second material are different ferrimagnets from each other.

10. A thermoelectric conversion device comprising:
a first substrate;
a plurality of first thermoelectric conversion elements on the first substrate, each of the plurality of first thermoelectric conversion elements having a shape extending in one direction, being made of a first material that is able to be magnetized in any direction at zero magnetic field, and being configured to exhibit an anomalous Nernst effect, the plurality of first thermoelectric conversion elements being arranged in parallel to one another in a direction perpendicular to the one direction;
a second substrate; and
a plurality of second thermoelectric conversion elements on the second substrate, each of the plurality of second thermoelectric conversion elements having a shape extending in the one direction, being made of a second material that is able to be magnetized in any direction at zero magnetic field, and being configured to exhibit the anomalous Nernst effect, the plurality of second thermoelectric conversion elements being arranged in parallel to one another in a direction perpendicular to the one direction, wherein
Nernst coefficients of the first material and the second material are opposite in sign to each other, and
the plurality of first thermoelectric conversion elements and the plurality of second thermoelectric conversion elements are connected alternately and electrically in series such that the plurality of first thermoelectric conversion elements and the plurality of second thermoelectric conversion elements are magnetized in an identical direction.

11. The thermoelectric conversion device according to claim 10, wherein
the first material and the second material are different ferrimagnets from each other.
